Europäisches Patentamt

European Patent Office

Office européen des brevets

(19)

(11) **EP 1 133 127 A2**

(12) **EUROPÄISCHE PATENTANMELDUNG**

(43) Veröffentlichungstag:
**12.09.2001 Patentblatt 2001/37**

(51) Int Cl.⁷: **H04L 27/20**

(21) Anmeldenummer: **01200758.9**

(22) Anmeldetag: **28.02.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **07.03.2000 DE 10011061**

(71) Anmelder:
• **Philips Corporate Intellectual Property GmbH 52064 Aachen (DE)**
Benannte Vertragsstaaten:
**DE**
• **Koninklijke Philips Electronics N.V. 5621 BA Eindhoven (NL)**
Benannte Vertragsstaaten:
**FR GB**

(72) Erfinder:
• **Birth, Winfried 52064 Aachen (DE)**
• **Fröhlich, Andreas 52064 Aachen (DE)**

(74) Vertreter: **Gössmann, Klemens Philips Corporate Intellectual Property GmbH Habsburgerallee 11 52064 Aachen (DE)**

(54) **Sender und Verfahren zum Erzeugen eines Sendesignals**

(57)    Die Erfindung betrifft einen Sender und ein Verfahren zum Erzeugen eines Sendesignals. Eine erste Modulationseinrichtung 12 erzeugt ein unkompensiertes Sendesignal Y(t) durch Modulieren von mindestens einem Basisbandsignal I, Q mit jeweils einem Oszillationssignal LOQ, LOI. Die Aufgabe der Erfindung besteht darin, einen Sender mit einer derartigen Modulationseinrichtung so weiterzubilden, dass der Aufwand für eine nachträgliche Filterung zur Dämpfung von unerwünschten Anteilen in dem unkompensierten Sendesignal Y(t) reduziert wird. Diese Aufgabe wird erfindungsgemäß dadurch gelöst, dass am Ausgang einer zweiten Modulationseinrichtung 14 ein Kompensationssignal C (t) bereitgestellt wird, welches im wesentlichen die zu kompensierenden Anteile in dem unkompensierten Sendesignal Y(t) repräsentiert. Das Kompensationssignal wird in der zweiten Modulationseinrichtung durch Modulieren der Basisbandsignale I, Q mit geeigneten Hilfsoszillationssignalen erzeugt. Zum Erzeugen eines zumindest teilweise kompensierten Sendesignals Y'(t) wird das Kompensationssignal C(t) von dem unkompensierten Sendesignal Y(t) subtrahiert.

FIG. 1

EP 1 133 127 A2

**Beschreibung**

Die Erfindung betrifft einen Sender, insbesondere einen Mobilfunksender, zum Erzeugen eines Sendesignals mit einer ersten Modulationseinrichtung zum Erzeugen eines unkompensierten Sendesignals durch Modulieren von mindestens einem Basisbandsignal mit jeweils einem Oszillationssignal.

Die Erfindung betrifft weiterhin ein Verfahren zum Betreiben des Senders.

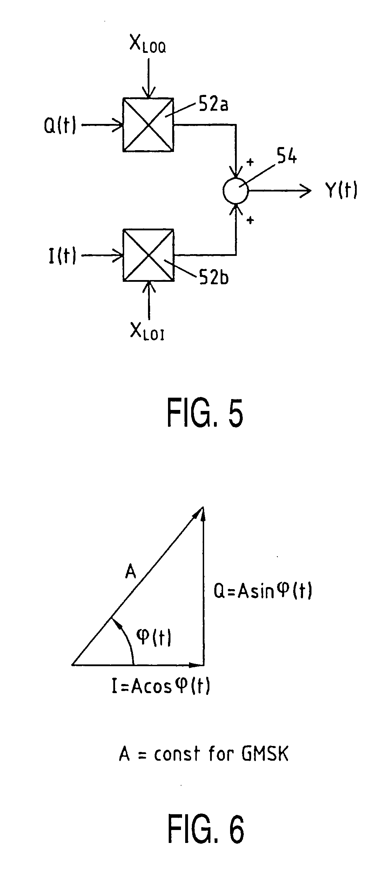

Ein derartiger Sender ist z.B. von dem integrierten Schaltkreis PMB 2200, hergestellt von der Siemens AG, bekannt. Der Sender enthält eine Modulationseinrichtung, genauer gesagt einen Quadraturmodulator, wie er vereinfacht in Fig. 5 dargestellt ist.

Der in Fig. 5 dargestellte Quadraturmodulator weist zwei Modulatoren 52a, 52b auf, die jeweils ein Basisbandsignal I(t), Q(t) mit einem zugeordneten Oszillationssignal $X_{L0Q}$, $X_{L0I}$ multiplizieren.

Bei den Basisbandsignalen I, Q handelt es sich um karthesische Komponenten eines rotierenden Zeigers A, wie dies in Fig. 6 veranschaulicht ist. Beispielhaft ist dort zu erkennen, dass es sich bei dem Basisbandsignal I um eine Kosinusschwingung und bei dem Basisbandsignal Q um eine Sinusschwingung mit jeweils betragsgleicher Amplitude A handelt. Eine betragsgleiche Amplitude ist z.B. bei dem Mobilfunkstandard GMSK vorgesehen.

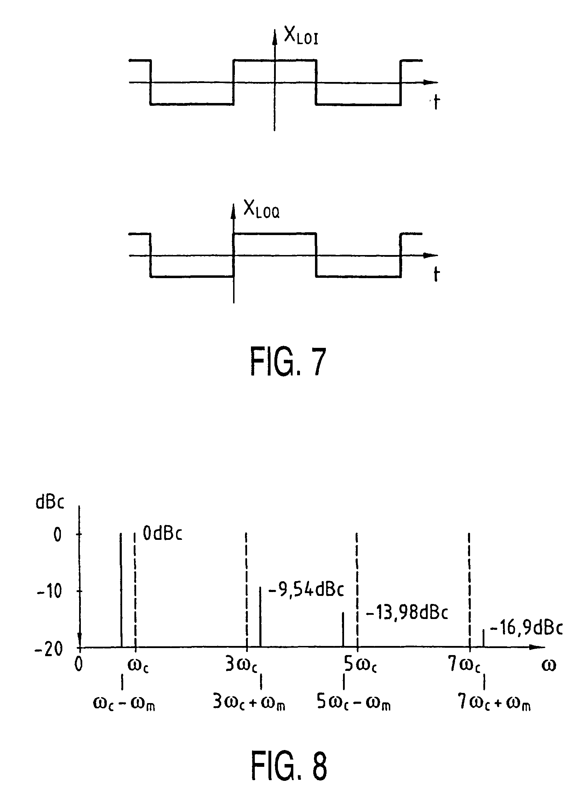

Bei den in Fig. 7 dargestellten Oszillationssignalen $X_{L0I}$ und $X_{L0Q}$ handelt es sich um binäre Schaltsignale, die um 90° gegeneinander phasenverschoben sind.

Der erste Modulator 52a in Fig. 5 moduliert das Basisbandsignal Q(t) mit dem ersten Oszillationssignal $X_{L0Q}$ und der zweite Modulator 52b moduliert das Basisbandsignal I(t) mit dem Oszillationssignal $X_{L0I}$. Die Ausgänge der beiden Modulatoren werden in der Additionseinrichtung 54 additiv zu einem Sendesignal Y(t) verknüpft.

Weil es sich bei den Oszillationssignalen gemäß Fig. 7 um binäre Schaltsignale handelt, lassen sie sich mit Hilfe einer Fourier-Tansfbrmation in eine Grundwelle und in eine Vielzahl von Oberwellen zerlegen. Für das Oszillationssignal $X_{L0I}$ ergibt sich dann folgende Darstellung:

$$x_{L0I}=\cos\omega_c t-\frac{1}{3}\cos 3\omega_c t+\frac{1}{5}\cos 5\omega_c t-\frac{1}{7}\cos 7\omega_c t \qquad (1)$$

und für das Oszillationssignal $X_{L0Q}$ ergibt sich

$$x_{L0Q}=\sin\omega_c t+\frac{1}{3}\sin 3\omega_c t+\frac{1}{5}\sin 5\omega_c t+\frac{1}{7}\sin 7\omega_c t \qquad (2)$$

Das Sendesignal Y(t) am Ausgang des in Fig. 5 gezeigten Quadraturmodulators ergibt sich dann zu

$$y(t) = X_{L0I}(t)\cdot\cos\omega_m t \overset{+}{(-)} X_{L0Q}(t)\sin\omega_m t \qquad (3)$$

$$= \cos(\omega_{c\underset{(+)}{-}}\omega_m)\,t-\frac{1}{3}\cos(3\omega_c\overset{+}{(-)}\omega_m)\,t + \frac{1}{5}\cos(5\omega)_{c\underset{(+)}{-}}\omega_m)\,t \qquad (4)$$

Diese Darstellung für das Sendesignal Y(t) ergibt sich unter Berücksichtigung folgender Gleichungen und Additionstheoreme:

$$Y(t)=A\cos\varphi(t)\cdot\cos\omega_c t\overset{+}{(-)} A\sin\varphi(t)\cdot\sin\omega_c t \qquad (5)$$

$$\cos\alpha\,\cos\beta = \frac{1}{2}\,[\cos(\alpha-\beta)+\cos(\alpha+\beta)] \qquad (6)$$

$$\sin\alpha\,\sin\beta = \frac{1}{2}\,[\cos(\alpha-\beta)-\cos(\alpha+\beta)] \qquad (7)$$

$$Y(t) = A\cos(\omega_c t\overset{-}{(+)}\varphi(t)) \qquad (8)$$

Aus Gleichung 4 ist ersichtlich, dass das Sendesignal Y(t) neben der Grundwelle $\cos(\omega_c\overline{(+)}\omega_m)\cdot t$ auch eine Vielzahl von Oberwellen und insbesondere eine dritte Oberwelle $\cos(3\omega_c\overset{+}{(-)}\omega_m)\,t$ aufweist. Wie aus den Gleichungen 1 und 2 ersichtlich, werden die Oberwellen in dem Sendesignal Y(t) durch die Oberwellen in den Oszillationssignalen $X_{L0I}$ und $X_{L0Q}$ verursacht. Fig. 8 zeigt ein Diagramm, welches die Amplituden der einzelnen Oberwellen im Vergleich zu einer auf 1 normierten Amplitude der Grundwelle veranschaulicht. Es ist zu erkennen, dass die dritte Oberwelle die größte Amplitude von allen Oberwellen aufweist, wobei der Betrag ihrer Amplitude bei einem Drittel der Amplitude der Grundwelle liegt, d.h. gegenüber dieser nur um 9,54 dB gedämpft ist.

Weil das Sendesignal Y(t) nicht nur die Grundwelle, sondern auch die Oberwellen aufweist, ist es insofern unkompensiert. Die Oberwellen im Sendesignal sind unerwünscht und wurden bisher durch eine nachträgliche Tiefpass-Filterung beseitigt. Für vorgesehene Anwendungen im Mobilfunkbereich ist jedoch eine Dämpfung der dritten Oberwelle am Ausgang der Addiereinrichtung 54 um 40 dB erforderlich, was nur durch einen erheblichen Filteraufwand realisierbar ist. Ein entsprechend geeignetes Filter ist bisher nur als externe Schaltung zu einem integrierten Sender realisierbar. Eine Integration von Modulationseinrichtung und Filter auf einem Chip war deshalb bisher nicht möglich.

Ausgehend von diesem Stand der Technik ist es die Aufgabe der vorliegenden Erfindung, einen Sender und ein Verfahren der eingangs genannten Art derart weiterzubilden, dass der Aufwand für eine nachträgliche Filterung des Sendesignals reduziert wird.

Diese Aufgabe durch den Gegenstand des Patentanspruchs 1 sowie durch das Verfahren gemäß Patentanspruch 9 gelöst.

Für den eingangs genannten Sender wird die Aufgabe gemäß Patentanspruch 1 dadurch gelöst, dass er weiterhin eine zweite Modulationseinrichtung zum Erzeugen eines Kompensationssignals, welches im wesentlichen die zu kompensierenden Anteile in dem unkompensierten Sendesignal repräsentiert, durch Modulieren des Basisbandsignals mit einem geeigneten Hilfsoszillationssignal, und eine Subtraktionseinrichtung aufweist zum Subtrahieren des Kompensationssignals von dem unkompensierten Sendesignal und zum Ausgeben eines zumindest teilweise kompensierten Sendesignals.

Ein derartig aufgebauter Sender hat den Vorteil, dass unerwünschte Oberwellenanteile in dem von ihm erzeugten Sendesignal zumindest teilweise kompensiert sind. Die Kompensation kann sich z.B. in einer wesentlichen Reduzierung der Amplitude einzelner Oberwellenanteile zeigen. Der Aufwand für ein dem Sender nachgeschaltetes Filter zur Dämpfung von weiteren, in dem zumindest teilweise kompensierten Sendesignal noch enthaltenen Oberwellenanteilen ist dann wesentlich geringer als für das unkompensierte Sendesignal gemäß dem Stand der Technik.

Wenn die erfindungsgemäße Kompensation innerhalb des Senders insbesondere die Kompensation der dominanten Oberwellen umfasst, kann ein nachgeschaltetes Filter sogar zusammen mit dem Sender auf einem Chip integriert werden.

Gemäß einer ersten Ausgestaltung der Erfindung ist es vorteilhaft, die Amplitude des Hilfsoszillationssignals so zu wählen, dass das am Ausgang der zweiten Modulationseinrichtung erzeugte Kompensationssignal eine gewünschte Amplitude aufweist.

Alternativ dazu ist es vorteilhaft, wenn die Amplitude des Kompensationssignals durch eine Dämpfungseinrichtung auf einen gewünschten Pegel angepasst werden kann.

Die Erzeugung des Oszillationssignals und des Hilfsoszillationssignals gestaltet sich besonders einfach bei Verwendung von Ringschieberegistern.

Es ist besonders vorteilhaft, wenn das Kompensationssignal im wesentlichen die dritte Oberwelle des unkompensierten Sendesignals repräsentiert, weil diese bei der Verwendung von binären Oszillationsschaltsignalen gegenüber anderen Oberwellen dominant ist und aufgrund der Nähe ihrer Frequenz zur Frequenz der Grundwelle am schwierigsten in einem nachgeschalteten Filter zu eliminieren ist.

Ein dem Sender nachgeschaltetes Tiefpassfilter kann vorteilhafterweise zur Dämpfung von nach der Kompensation in dem Sendesignal verbliebenen Oberwellenanteilen dienen.

Bei Verwendung von jeweils n-Modulatoren und n-1-Additionseinrichtungen in der ersten und zweiten Modulationseinrichtung kann eine Vielzahl von n-Basisbandsignalen moduliert und zur Erzeugung eines zumindest teilweise kompensierten Sendesignals verwendet werden.

Die Aufgabe wird weiterhin durch ein Verfahren zum Erzeugen eines Sendesignals gelöst. Die Vorteile dieses Verfahrens entsprechend den bisher für den Sender genannten Vorteilen.

Der Anmeldung sind die Fig. 1 bis 8 beigefügt, wobei

Fig. 1      einen Sender gemäß einem ersten Ausführungsbeispiel der Erfindung,

Fig. 2      einen Sender gemäß einem zweiten Ausführungsbeispiel der Erfindung,

Fig. 3      Verläufe von Basisband und Oszillationssignalen für den Sender gemäß Fig. 2,

Fig. 4      Ringschieberegister zur Erzeugung der Oszillations- und Hilfsoszillationssignale,

Fig. 5    einen Quadraturmodulator gemäß dem Stand der Technik,

Fig. 6    ein Beispiel zur Herleitung von Basisbandsignalen I, Q gemäß dem Stand der Technik,

Fig. 7    Beispiele für Oszillationssignale gemäß dem Stand der Technik und

Fig. 8    ein Diagramm zur Veranschaulichung der Gewichtung von Oberwellen im Vergleich zur Grundwelle bei einem unkompensierten Sendesignal zeigt.

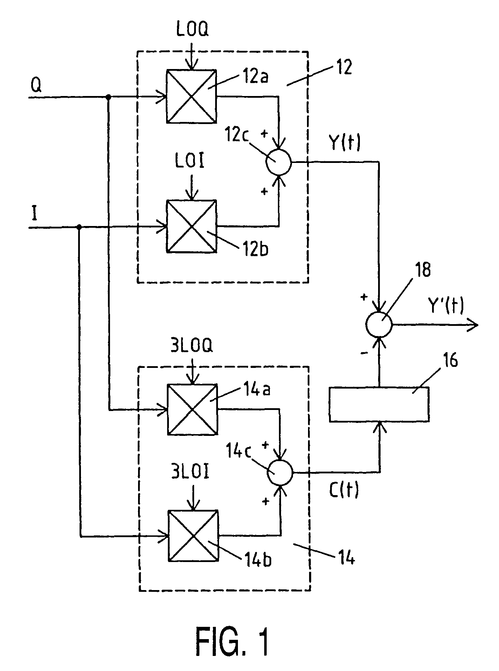

Fig. 1 zeigt einen Sender, insbesondere Mobilfunksender, zum Erzeugen eines zumindest teilweise unkompensierten Sendesignals Y'(t). Der Sender weist eine erste Modulationseinrichtung 12 zum Erzeugen eines unkompensierten Sendesignals Y(t) durch Modulieren von mindestens einem Basisbandsignal I, Q mit jeweils einem Oszillationssignal LOQ, LOI, 3LOQ, 3LOI, auf. Der Sender umfasst weiterhin eine zweite Modulationseinrichtung 14 zum Erzeugen eines Kompensationssignals C(t), welches im wesentlichen die zu kompensierenden Anteile in dem unkompensierten Sendesignal Y(t) repräsentiert. Das gewünschte Kompensationssignal C(t) wird erzeugt durch Modulieren der ersten Modulationseinrichtung 12 zugeführten Basisbandsignale I, Q mit jeweils einem geeigneten Hilfsoszillationssignal 3LOQ, 3LOI.

Sofern erforderlich, wird die Amplitude des Kompensationssignals C(t) von einer Dämpfungseinrichtung 16 betragsmäßig an die Amplitude des zu kompensierenden Störanteils in dem unkompensierten Sendesignal angepasst, bevor es in einer Subtraktionseinrichtung 18 von dem unkompensierten Sendesignal subtrahiert wird. Die Subtraktionseinrichtung 18 stellt an ihrem Ausgang ein zumindest teilweise kompensiertes Sendesignal Y'(t) bereit.

Die erste und zweite Modulationseinrichtung 12, 14 entsprechen in ihrem Aufbau und ihrer Funktionsweise jeweils dem oben beschriebenen und aus dem Stand der Technik bekannten Quadraturmodulator.

In dem in Fig. 1 dargestellten Sender werden beispielhaft zwei Basisbandsignale moduliert, um das umkompensierte Sendesignal Y(t) und das Kompensationssignal C(t) zu erzeugen. In Abwandlung dieses Beispiels ist es allerdings auch denkbar, das Sendesignal Y(t) und das Kompensationssignal C(t) jeweils durch Modulation von n mit n>1 zu erzeugen. Es sind dann jeweils n-Modulatoren und n-1-Additionseinrichtungen zur Erzeugung des Sendesignals Y(t) und des Kompensationssignals C(t) erforderlich.

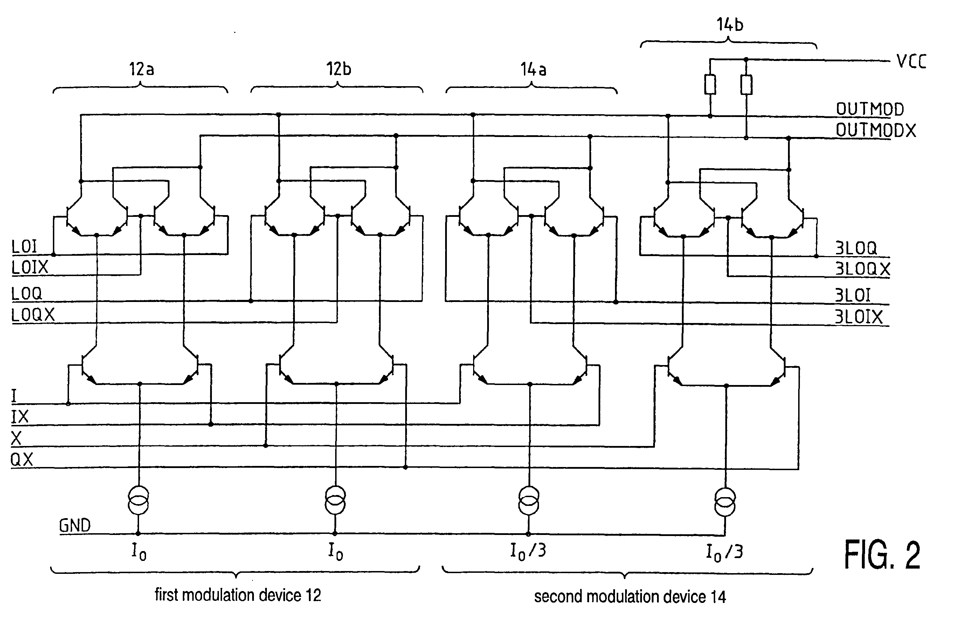

Fig. 2 zeigt ein zweites Ausführungsbeispiel des erfindungsgemäßen Senders in Form einer Transistorschaltung. In Fig. 2 wird die erste und zweite Modulationseinrichtung 12 und 14 gezeigt, welche jeweils einen ersten und zweiten Modulator 12a, 12b, 14a, 14b aufweisen. Die beiden Modulationseinrichtungen 12, 14 entsprechen den in Fig. 1 symbolisch dargestellten Modulationseinrichtungen. Die ersten Modulatoren 12a und 14a empfangen jeweils das Basisbandsignal I und dessen Invertierung IX. Die zweiten Modulatoren 12b und 14b empfangen jeweils das Basisbandsignal Q und dessen Invertierung QX.

Zur Modulation des Basisbandsignals I und dessen Invertierung IX empfängt der erste Modulator 12a der ersten Modulationseinrichtung 12 die Oszillationssignale LOI und LOIX. Zur Modulation der Basisbandsignale Q und dessen Invertierung QX empfängt der zweite Modulator 12b der ersten Modulationseinrichtung 12 die Oszillationssignale LOQ und LOQX.

Zur Erzeugung einer ersten Teilkomponente für das Kompensationssignal empfängt der erste Modulator 14a der zweiten Modulationseinrichtung 14 die Hilfsoszillationssignale 3LOI und dessen Invertierung 3LOIX zur Modulation mit jeweils einem der Basisbandsignale I und IX. In analoger Weise arbeitet der zweite Modulator 14b der zweiten Modulationseinrichtung 14, indem er die Hilfsoszillationssignale 3LOQ und 3LOQX jeweils zur Modulation mit einem der Basisbandsignale Q und QX empfängt.

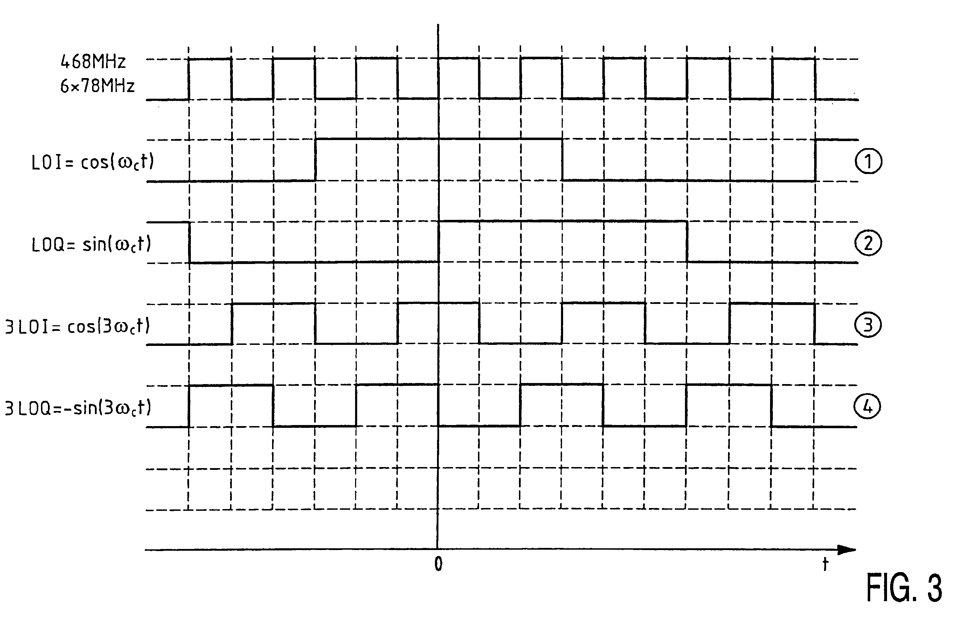

Alle vier Modulatoren 12a, 12b, 14a und 14b werden von individuell zugeordneten Stromquellen I0 gespeist. Dabei ist zu beachten, dass in dem Beispiel gemäß Fig. 3 die Modulatoren der zweiten Modulationseinrichtung 14 lediglich mit einem Strom gespeist werden, dessen Betrag nur ein Drittel des Strombetrags ausmacht, mit dem die Modulatoren der ersten Modulationseinrichtung 12 gespeist werden. Auf diese Weise wird über den Betrag der Stromstärke die Amplitude des Kompensationssignals C(t) gemäß Fig. 1 gesteuert. Idealerweise wird die Amplitude des Kompensationssignals dabei so gewählt, dass die Dämpfungseinrichtung 16 gemäß Fig. 1 entbehrlich wird. Darin liegt der Unterschied zwischen dem ersten und zweiten Ausführungsbeispiel.

In der Schaltung gemäß Fig. 2 bezeichnen die Abkürzungen OUTMOD und. OUTMODX das zumindest teilweise kompensierte Sendesignal und dessen Invertierung. Weiterhin bezeichnen die Abkürzungen VCC und GND eine Spannungsversorgung für die Schaltung und deren Masseverbindung. Die in Fig. 2 gezeigte Schaltung ist zur Integration auf einem Chip geeignet. Sie ist weiterhin für eine Integration zusammen mit einem nachgeschalteten Filter auf einem Chip geeignet. Dabei könnte das Filter zur nachträglichen Dämpfung von weiteren noch in dem teilweise kompensierten Sendesignal enthaltenen Störkomponenten dienen.

Fig. 3 zeigt die Verläufe der Oszillationssignale LOI und LOQ sowie der Hilfsoszillationssignale 3LOI und 3LOQ. Es ist zu erkennen, dass alle diese Signale durch Frequenzteilung aus einem vorgegebenen Taktsignal, welches gemäß Fig. 3 beispielhaft eine Frequenz von 468 MHz aufweist, gewonnen werden können. In dem zweiten Ausführungsbeispiel gemäß Fig. 2 und 3 ist es das Ziel der Kompensation, die dritte Oberwelle in dem unkompensierten Sendesignal am Ausgang der ersten Modulationseinrichtung 12 zu kompensieren. Zu diesem Zweck wird die zweite Modulationseinrichtung mit Hilfsoszillationssignalen 3LOI und 3LOQ beaufschlagt, welche jeweils die dritte Oberwelle der Oszillationssignale LOI und LOQ repräsentieren. Dies ist insbesondere in Fig. 3 daran zu erkennen, dass die Hilfsoszillationssignale 3LOI und 3LOQ die dreifache Frequenz wie die zugehörigen Oszillationssignale aufweisen.

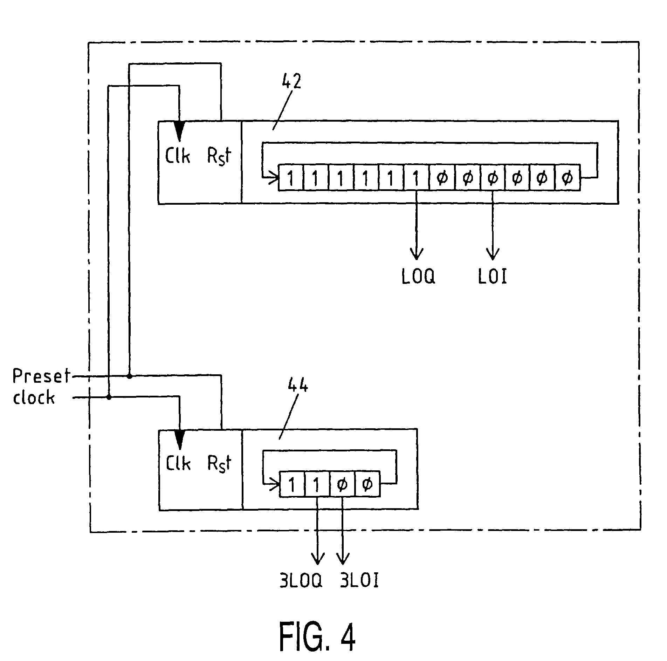

Fig. 4 zeigt ein einfaches Beispiel zur Erzeugung der Oszillations- und Hilfsoszillationssignale gemäß Fig. 3 aus einem Taktsignal durch Verwendung von Ringschieberegistern 42 und 44. Die Ringschieberegister 42, 44 sind jeweils zur Hälfte mit l'en und 0'en vorbesetzt. Bei Beaufschlagung der beiden Ringschieberegister mit dem Taktsignal können die gewünschten Oszillations- und Hilfsoszillationssignale einfach an geeigneten Ausgängen der Ringschieberegister abgegriffen werden.

## Patentansprüche

1.  Sender, insbesondere Mobilfunksender, zum Erzeugen eines Sendesignals Y(t), mit:

    einer ersten Modulationseinrichtung (12) zum Erzeugen eines unkompensierten Sendesignals Y(t) durch Modulieren von mindestens einem Basisbandsignal I, Q mit jeweils einem Oszillationssignal LOQ, LOI,
    **gekennzeichnet durch** eine zweite Modulationseinrichtung (14) zum Erzeugen eines Kompensationssignals C(t), welches im wesentlichen die zu kompensierenden Anteile in dem unkompensierten Sendesignal Y(t) repräsentiert, durch Modulieren des Basisbandsignals I, Q mit einem Hilfsoszillationssignal 3LOQ, 3LOI, und eine Subtraktionseinrichtung (18) zum Subtrahieren des Kompensationssignals C(t) von dem unkompensierten Sendesignal Y(t) und zum Ausgeben eines zumindest teilweise kompensierten Sendesignals Y'(t).

2.  Sender nach Anspruch 1,
    **dadurch gekennzeichnet,**
    **dass** die Amplitude des Hilfsoszillationssignals 3LOQ, 3L0I so gewählt wird, dass die Amplitude des Kompensationssignals C(t) am Ausgang der zweiten Modulationseinrichtung (14) der Amplitude des zu kompensierenden Anteils in dem unkompensierten Sendesignal Y(t) entspricht.

3.  Sender nach Anspruch 1,
    **dadurch gekennzeichnet,**
    **dass** der Sender eine der zweiten Modulationseinrichtung (14) nachgeschaltete Dämpfungseinrichtung (16) aufweist, welche die Amplitude des Kompensationssignals an die Amplitude des zu kompensierenden Anteils in dem unkompensierten Sendesignal Y(t) anpasst, bevor das Kompensationssignal C(t) der Subtraktionseinrichtung (18) zugeführt wird.

4.  Sender nach einem der Ansprüche 1 bis 3,
    **dadurch gekennzeichnet,**
    **dass** der Sender ein erstes Ringschieberegister (42) zum Erzeugen der Oszillationssignale LOQ oder LOI und/oder ein zweites Ringschieberegister zum Erzeugen der Hilfsoszillationssignale 3LOQ oder 3LOI aufweist.

5.  Sender nach einem der Ansprüche 1 bis 4,
    **dadurch gekennzeichnet,**
    **dass** das Kompensationssignal C(t) im wesentlichen die dritte Oberwelle des unkompensierten Sendesignals Y(t) repräsentiert.

6.  Sender nach einem der Ansprüche 1 bis 5,
    **dadurch gekennzeichnet,**
    **dass** der Sender ein der Subtraktionseinrichtung (18) nachgeschaltetes Tiefpassfilter zum Herausfiltern von weiteren in dem teilweise kompensierten Sendesignal Y'(t) noch enthaltenen unerwünschten Anteilen aufweist.

7.  Sender nach einem der Ansprüche 1 bis 6,
    **dadurch gekennzeichnet,**
    **dass** die erste Modulationseinrichtung (12) aufweist:

    n-Modulatoren (12a, 12b) zum Erzeugen von n-Zwischensignalen durch Modulieren von jeweils einem von n-Basisbandsignalen I, Q mit jeweils einem Modulationssignal LOQ, LOI und
n-1-Additionseinrichtungen (12c) zum Erzeugen des unkompensierten Sendesignals Y(t) durch Addition der Zwischensignale.

8. Sender nach einem der Ansprüche 1 bis 7,
**dadurch gekennzeichnet,**
**dass** die zweite Modulationseinrichtung (14) aufweist:

n-Modulatoren (14a, 14b) zum Erzeugen von n-Kompensationszwischensignalen durch Modulieren von jeweils einem der n-Basisbandsignale IQ mit jeweils einem Hilfsoszillationssignal 3LOQ, 3LOI, und
n-1-Additionseinrichtungen (14c) zum Erzeugen des Kompensationssignals durch Addition der Kompensationszwischensignale.

9. Verfahren zum Erzeugen eines Sendesignals y'(t) mit folgenden Schritten:

Erzeugen eines unkompensierten Sendesignals y(t) durch Modulieren von mindestens einem Basisbandsignal I, Q mit jeweils einem Oszillationssignal LOQ, LOI, **gekennzeichnet durch** Erzeugen eines Kompensationssignals C(t) durch Modulieren des Basisbandsignals I, Q mit einem Hilfsoszillationssignal 3LOQ, 3LOI,
wobei das Kompensationssignal im wesentlichen die zu kompensierenden Anteile in dem unkompensierten Sendesignal Y(t) repräsentiert und
durch Subtrahieren des Kompensationssignals C(t) von dem unkompensierten Sendesignal Y(t) zum Erzeugen eines zumindest teilweise kompensierten Sendesignals Y'(t).

FIG. 1

FIG. 2

first modulation device 12

second modulation device 14

468MHz
6×78MHz

LOI= cos(ω_c t)   ①

LOQ= sin(ω_c t)   ②

3LOI= cos(3ω_c t)   ③

3LOQ= -sin(3ω_c t)   ④

$t$

0

FIG. 3

FIG. 4

FIG. 5

A = const for GMSK

FIG. 6

$X_{LOI}$

t

$X_{LOQ}$

t

FIG. 7

dBc

0dBc

-9,54dBc

-13,98dBc

-16,9dBc

$\omega_c$   $3\omega_c$   $5\omega_c$   $7\omega_c$   $\omega$

$\omega_c - \omega_m$   $3\omega_c + \omega_m$   $5\omega_c - \omega_m$   $7\omega_c + \omega_m$

FIG. 8